Europäisches Patentamt

European Patent Office

Office européen des brevets

(19)

(11) **EP 0 453 758 B1**

(12) **FASCICULE DE BREVET EUROPEEN**

(45) Date de publication et mention
de la délivrance du brevet:
**01.05.1996 Bulletin 1996/18**

(51) Int Cl.⁶: **G06F 11/26**

(21) Numéro de dépôt: **91104175.4**

(22) Date de dépôt: **18.03.1991**

(54) **Système de test d'un circuit imprimé pourvu de circuits intégrés et application de ce système au test d'un tel circuit imprimé**

Mit integrierten Schaltungen versehene Prüfvorrichtung für eine gedruckte Schaltung und Anwendung dieser Vorrichtung zum Prüfen einer solchen gedruckten Schaltung

Test system comprising integrated circuits for a printed circuit and application of this system for testing said printed circuit

(84) Etats contractants désignés:
**AT BE CH DE DK ES FR GB GR IT LI LU NL SE**

(30) Priorité: **23.03.1990 FR 9003754**

(43) Date de publication de la demande:
**30.10.1991 Bulletin 1991/44**

(73) Titulaire: **ALCATEL MOBILE COMMUNICATION FRANCE**
**F-75008 Paris (FR)**

(72) Inventeur: **Castel, Dominique**
**F-92110 Clichy (FR)**

(74) Mandataire: **Weinmiller, Jürgen et al**
**Lennéstrasse 9**
**Postfach 24**
**D-82336 Feldafing (DE)**

(56) Documents cités:
**EP-A- 0 078 670      EP-A- 0 336 444**
**DE-A- 3 709 032      DE-C- 3 839 289**

- **1989 INTERNATIONAL TEST CONFERENCE PROCEEDING, "Meeting the tests of time", 29-31 août 1989, pages 63-70, IEEE, New York, US; N. JARWALA et al.: "A new framework for analyzing test generation and diagnosis algorithms for wiring interconnects"**

**Description**

La présente invention concerne un système de test d'un circuit imprimé pourvu de circuits intégrés et l'application de ce système au test d'un tel circuit imprimé.

Les cartes électroniques, de manière générale, comprennent des composants disposés sur un support tel qu'un circuit imprimé, les interconnexions des composants étant réalisées par des pistes conductrices solidaires de ce support. Ces cartes électroniques sont couramment soumises à des tests pour détecter d'éventuelles anomalies. Il s'avère que deux anomalies, le court-circuit entre deux pistes adjacentes et la coupure d'une piste, sont les plus fréquentes. Il est donc nécessaire de les détecter le plus rapidement possible et au moindre coût. De plus, lorsque des composants de la carte sont des circuits intégrés, il faut également vérifier le bon positionnement de leurs connexions en regard des pistes correspondantes.

Pour tester les connexions d'une telle carte, à savoir contrôler les trois points susmentionnés, il faut neutraliser l'action du (ou des) circuit (s) intégré (s) qu'elle comprend. Il est ainsi connu, par le brevet US- 4 812 678, d'établir dans un circuit intégré une liaison directe entre une de ses sorties et une de ses entrées. Cependant, si la carte comprend plusieurs circuits intégrés interconnectés, la mesure faite au voisinage d'un premier circuit intégré ne doit pas être perturbée par l'action éventuelle des autres circuits. La méthode de test consiste donc de plus, à supprimer fictivement, ces autres circuits, c'est-à-dire à isoler leurs sorties en les mettant à l'état de haute impédance. Lorsque un circuit intégré a des accès bidirectionnels, une solution consiste à les positionner en accès d'entrée.

On connaît une telle méthode notamment par la technique de test dite JTAG (Joint Test Action Group). Cette technique permet de révéler les trois anomalies précédemment évoquées, en introduisant, d'une part, quatre lignes conductrices supplémentaires sur le circuit imprimé reliant chacune une broche du connecteur de cette carte à une borne de chaque circuit intégré et d'autre part une cellule de test dans chaque circuit intégré, cette cellule nécessitant quatre bornes supplémentaires. Cette solution augmente la complexité du circuit imprimé et celle des circuits intégrés. De plus, la durée du test est relativement longue.

La présente invention a ainsi pour objet un système de test de circuit imprimé pourvu de circuits intégrés dans lesquels la cellule de test est simplifiée et présente un nombre réduit de bornes supplémentaires.

D'autre part, le système de test n'ajoute pas sur le circuit imprimé de pistes supplémentaires raccordées à son connecteur.

L'invention permet l'application de ce système de test au test d'un circuit imprimé pourvu de circuits intégrés comprenant de telles cellules de test.

Le système de test comprend également un équipement de test connu utilisant un organe de connexion du type carte à pointes ou planche à clous.

Le système de test d'un circuit imprimé pourvu de circuits intégrés selon l'invention comprend un équipement de test muni d'un organe de connexion, un circuit intégré au moins comprenant une cellule fonctionnelle et une cellule de test, le circuit imprimé comprenant des pistes fonctionnelles accédant à la cellule fonctionnelle et une piste de test au moins accédant à la cellule de test, cette cellule de test comprenant des moyens pour relier une entrée au moins et une sortie au moins de la cellule fonctionnelle en réponse à un signal d'activation dérivant de l'état des pistes de test, ces pistes de test étant propres au circuit intégré et l'organe de connexion accédant à chacune des pistes de test et des pistes fonctionnelles, et se caractérise en ce que la cellule de test comprend un module de commande (6) pour produire un signal de neutralisation (N) dérivant de l'état desdites pistes de test, et des moyens pour mettre toutes les sorties de la cellule fonctionnelle à l'état haute impédance en réponse audit signal de neutralisation.

En outre, lorsque dans le système de test d'un circuit imprimé pourvu de circuits intégrés le circuit intégré comprend des accès bidirectionnels, cette cellule de test comprend des moyens pour positionner ces accès bidirectionnels en accès d'entrée en réponse à un signal de positionnement dérivant de l'état des pistes de test.

Avantageusement, dans le système de test d'un circuit imprimé pourvu de circuits intégrés, la cellule fonctionnelle étant prévue pour recevoir un signal d'entrée au moins et pour appliquer un signal de sortie au moins à une cellule d'interface de sortie, la cellule de test est prévue pour recevoir un signal de test à deux états et un signal de vérification à deux états chacun par une dite piste de test, cette cellule de test comprenant un module d'activation produisant le signal d'activation pour une combinaison particulière des signaux de test et de vérification dite combinaison de dérivation.

Dans un mode de réalisation du système de test d'un circuit imprimé pourvu de circuits intégrés, la cellule d'interface de sortie étant une cellule à trois états, la cellule fonctionnelle est prévue pour produire de plus un signal de commande de cette cellule d'interface de sortie pour la mettre en état de haute impédance, ledit module de commande de ladite cellule de test reçoit le signal de vérification, le signal de test et le signal de commande et produit ledit signal de neutralisation soit pour une combinaison des signaux de vérification et de test distincte de la combinaison de dérivation dite combinaison d'isolement, soit, si ledit signal de commande est présent, pour les combinaisons des signaux de vérification et de test distinctes des combinaisons de dérivation et d'isolement.

Dans un autre mode de réalisation du système de test d'un circuit imprimé pourvu de circuits intégrés, la cellule fonctionnelle comprenant un accès bidirectionnel au moins composé d'une cellule d'interface d'entrée particulière et d'une cellule d'interface de sortie particulière et étant prévue pour produire un signal de commande bidirectionnel afin de mettre cette cellule d'interface de sortie particulière à l'état haute impédance, la cellule de test comprend un module de positionnement qui produit le signal de positionnement soit pour une combinaison des signaux de vérification et de test correspondant à la combinaison de dérivation ou à la combinaison d'isolement soit si ledit signal de commande bidirectionnel est présent, le signal bidirectionnel issu de ladite cellule d'interface d'entrée particulière étant alors undit signal d'entrée.

Dans une forme avantageuse du système de test d'un circuit imprimé pourvu de circuits intégrés, les moyens de test comprennent un multiplexeur au moins délivrant à une cellule d'interface de sortie un signal de multiplex prenant la valeur d'un signal d'entrée ou d'un signal de sortie selon que le signal d'activation est respectivement présent ou absent.

De plus, le système de test d'un circuit imprimé pourvu de circuits intégrés se caractérise en ce que la cellule de test comprend un module de jonction recevant plusieurs des signaux d'entrée particuliers et produisant un signal de jonction qui change de valeur dès qu'un des signaux d'entrée particulier change de valeur, le signal de jonction étant dorénavant un signal d'entrée.

Par exemple, dans le système de test d'un circuit imprimé pourvu de circuits intégrés, le module de jonction est un opérateur ou exclusif.

Dans une variante de réalisation du système de test d'un circuit imprimé pourvu de circuits intégrés, la cellule fonctionnelle étant prévue pour recevoir un signal de remise à zéro qui lui est propre, le signal de vérification est ce signal de remise à zéro.

Dans une application avantageuse du système de test d'un circuit imprimé pourvu de circuits intégrés l'équipement de test transmet un signal de test et un signal de vérification correspondant à la combinaison de dérivation à un circuit intégré dit circuit cible, transmet à tous les autres circuits intégrés comprenant une cellule de test des signaux de test et de vérification correspondant à la combinaison d'isolement, vérifie la transmission d'un signal témoin pour ses deux états d'une piste fonctionnelle d'entrée à une piste fonctionnelle de sortie au moins du circuit cible.

Dans une autre application du système de test d'un circuit imprimé pourvu de circuits intégrés, l'équipement de test transmet un signal de test et un signal de vérification correspondant à la combinaison de dérivation au circuit intégré dit circuit cible, transmet à tous les autres circuits intégrés comprenant une cellule de test des signaux de test et de vérification correspondant à la combinaison d'isolement, vérifie la transmission du signal de jonction à la piste de sortie correspondante du circuit cible tandis que des signaux témoins à deux états sont appliqués selon plusieurs combinaisons sur chaque piste fonctionnelle correspondant à un signal particulier d'entrée, une combinaison des signaux témoins se déduisant d'une autre combinaison par modification d'un seul signal témoin, chacun des signaux témoins étant alternativement dans ses deux états.

L'invention porte également sur un circuit intégré comprenant une cellule fonctionnelle et une cellule de test, conforme à l'une quelquonque des revendications 1 à 10.

Les différents objets et caractéristiques de l'invention apparaîtront maintenant avec plus de précision dans le cadre de la description d'exemples de réalisation donnés à titre non limitatif en se référant aux figures annexées qui représentent :

- la figure 1, un schéma d'un circuit intégré et d'une partie du circuit imprimé d'un premier mode de réalisation du système de test selon l'invention,
- la figure 2, un schéma d'un circuit intégré et d'une partie du circuit imprimé d'un deuxième mode de réalisation du système de test selon l'invention,
- la figure 3, un schéma d'un circuit intégré et d'une partie du circuit imprimé d'un troisième mode de réalisation du système de test selon l'invention,
- la figure 4, un schéma d'une partie d'un circuit intégré d'un quatrième mode de réalisation du système de test selon l'invention.

Les éléments présents dans différentes figures porteront une seule référence.

Le système de test selon l'invention comprend outre un équipement de test connu, un circuit imprimé et un ou plusieurs circuits intégrés aménagés pour les besoins de test.

Un tel circuit intégré comprend une cellule fonctionnelle assurant la fonction propre de ce circuit et une cellule de test qui permet soit de transmettre une entrée vers une sortie, soit de mettre une sortie en haute impédance. La cellule fonctionnelle, est prévue pour recevoir un signal de remise à zéro ; elle est donc soit en état de fonctionnement, soit en état de remise à zéro. Il apparaît donc que le circuit intégré doit fonctionner selon quatre modes distincts, ce qui nécessite, pour le commander, deux signaux binaires. Disposant déjà du signal de remise à zéro (R) il est donc nécessaire d'utiliser un signal supplémentaire, le signal de test (T).

Les quatre modes de fonctionnement suivant la valeur de ces signaux binaires sont représentés dans le tableau suivant :

| R | T | MODE |
|---|---|---|
| 0 | 1 | Remise à zéro |
| 1 | 1 | Fonctionnement normal |
| 0 | 0 | Isolement : Mise à l'état haute impédance des accès de sortie et des accès bidirectionnels |
| 1 | 0 | Dérivation : Positionnement des accès bidirectionnels en entrée et transmission des entrées aux sorties |

Dans la suite de la description, on considérera que le circuit intégré présente les caractéristiques suivantes qui sont connues :

- chaque accès d'entrée est suivi d'une cellule d'interface d'entrée,
- chaque accès de sortie est précédé d'une cellule d'interface trois états dont la mise en haute impédance est activée par un signal de commande,
- chaque accès bidirectionnel, s'il en existe, comprend une cellule d'interface d'entrée en parallèle sur une cellule d'interface trois états, il est positionné en accès d'entrée lorsque cette dernière cellule est mise en haute impédance suite à la réception d'un signal de commande.

Les pistes du circuit imprimé accèdant à une cellule fonctionnelle seront conventionnellement dénommées pistes fonctionnelles, tandis que celles accèdant à une cellule de test seront dénommées pistes de test.

Quatre cas particuliers de l'invention seront successivement exposés :

1) le circuit intégré comprend un accès d'entrée et un accès de sortie,
2) le circuit intégré comprend deux accès d'entrée et un accès de sortie,
3) le circuit intégré comprend un accès d'entrée et deux accès de sortie,
4) le circuit intégré comprend un accès bidirectionnel.

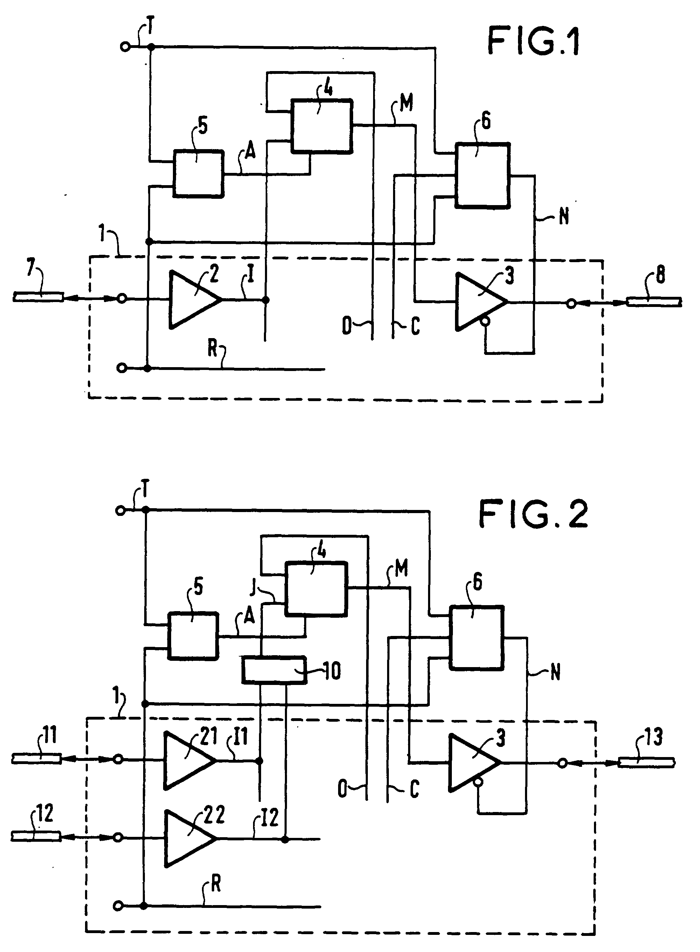

Le cas où le circuit intégré comprend un accès d'entrée et un accès de sortie est représenté à la figure 1.

Le circuit comprend une cellule fonctionnelle 1 qui ne sera pas explicitée car elle ne fait pas l'objet de l'invention. Cette cellule fonctionnelle délimitée par un trait pointillé sur la figure est prévue, notamment,

- pour recevoir un signal d'entrée I derrière une cellule d'interface d'entrée 2,
- pour recevoir un signal de remise à zéro R,
- pour produire un signal de sortie 0, qui en l'absence de l'invention, serait appliqué directement sur l'entrée d'une cellule d'interface de sortie trois états 3 de cette cellule fonctionnelle,
- pour produire un signal de commande C, qui, en l'absence de l'invention, serait appliqué directement sur l'entrée de commande de cette cellule d'interface de sortie 3 pour l'amener en état haute impédance.

Le circuit intégré comprend, selon l'invention, une cellule de test qui incorpore tous les éléments ne figurant pas dans la cellule fonctionnelle.

Cette cellule de test comprend un multiplexeur 4 qui produit un signal de multiplex M prenant la valeur du signal d'entrée I ou du signal de sortie 0 selon que la valeur d'un signal d'activation A binaire est respectivement zéro ou un.

Le signal d'activation A est élaboré par un module d'activation 5 qui reçoit un signal de test T et le signal de remise à zéro R. Sa valeur est définie par l'équation logique :

$$A = R . \overline{T}$$

La cellule d'interface de sortie 3 de la cellule fonctionnelle reçoit en entrée le signal de multiplex M et comme commande de mise en haute impédance le signal de neutralisation N qui doit être actif en mode isolement (R=0 et T=0) et en mode fonctionnement normal si le signal de commande est présent (T=1 et C=1). Le signal de neutralisation est élaboré par un module de commande 6 qui reçoit le signal de test T, le signal de remise à zéro R et le signal de commande C issu de la cellule fonctionnelle 1. Sa valeur est donnée par l'équation logique :

$$N = \overline{T} . \overline{R} + T . C$$

Ainsi, lorsque le signal de test vaut zéro, le fonctionnement du circuit intégré correspond à celui de la cellule fonctionnelle :le signal délivré par la cellule d'interface de sortie 3 vaut le signal de sortie 0 sous réserve que le signal de commande C soit nul.

En mode isolement (R=0, T=0) la cellule d'interface de sortie 3 est en haute impédance.

En mode dérivation (R=1, T=0) la cellule d'interface de sortie 3 délivre le signal d'entrée I.

La procédure de test consiste à appliquer un signal témoin prenant successivement les valeurs 1 et 0 sur une piste d'entrée 7 du circuit imprimé correspondant au signal d'entrée I et à vérifier sur une piste de sortie 8 correspondant au signal de multiplex M que l'information binaire est bien transmise.

Le mode de réalisation se généralise facilement au cas où le circuit intégré comprend autant d'entrées que de sorties. La cellule comprendra donc des multiplexeurs recevant chacun un signal d'entrée et un signal de sortie de la cellule fonctionnelle et des modules de commande recevant chacun un signal de commande associé à une sortie de la cellule fonctionnelle, le signal de test T et le signal de remise à zéro R. Elle comprendra un seul module d'activation 5 distribuant le signal d'activation A à chacun des multiplexeurs.

Toutefois il faut éviter, lors de la procédure de test, d'appliquer un même signal sur deux pistes adjacentes, ce qui pourrait masquer un court-circuit entre celles-ci.

Le cas où le circuit intégré comprend deux accès d'entrée et un accès de sortie est représenté à la figure 2.

Le circuit comprend une cellule fonctionnelle 1 à laquelle l'ensemble des considérations précisées au cours du premier cas s'appliquent si ce n'est qu'elle est prévue pour recevoir un premier signal d'entrée I1 derrière une première cellule d'interface d'entrée 21 et un deuxième signal d'entrée I2 derrière une deuxième cellule d'interface d'entrée 22.

La cellule de test se distingue de celle décrite dans le cas précédent uniquement par le fait que le signal appliqué sur l'entrée du multiplexeur 4 qui était le signal d'entrée I est maintenant le signal de jonction J.

Ce signal de jonction J est élaboré par un module de jonction 10 qui effectue une combinaison des premiers I1 et deuxièmes I2 signaux d'entrée qu'il reçoit. Ce module prendra ici la forme d'un opérateur logique dont le signal de sortie change de valeur lorsqu'une seule des deux entrées change de valeur. C'est en effet une condition nécessaire et suffisante pour détecter un défaut sur l'une quelconque des entrées. Cet opérateur sera, par exemple, un ou exclusif :

$$J = I1 \oplus I2 = \overline{I1} \cdot I2 + I1 \cdot \overline{I2}$$

La procédure de test sera maintenant explicitée. Un vecteur de test appliqué sur les pistes d'entrée 11 et 12 du circuit imprimé correspondant aux signaux d'entrée I1 et I2 prend successivement les valeurs suivantes :

$$V1 = 0,0$$
$$V2 = 1,0$$
$$V3 = 1,1$$

Il est en effet nécessaire que chaque piste en entrée reçoive des signaux ayant alternativement la valeur 0 ou 1. Il est également impératif que chaque valeur du vecteur de test se déduise d'une autre valeur de ce vecteur par modification d'une seule entrée.

La valeur du signal sur la piste de sortie 13 du circuit imprimé correspondant au signal de multiplex M prend respectivement les valeurs M1, M2, M3. L'analyse de ce triplet révèle l'état du circuit imprimé comme le précise le tableau suivant :

| M1 | M2 | M3 | |
|----|----|----|---|
| 0 | 0 | 0 | pistes 11 et 12 en court-circuit ou piste 13 en permanence à 0 |
| 0 | 0 | 1 | piste 11 en permanence à 0 |
| 0 | 1 | 0 | fonctionnement correct |
| 0 | 1 | 1 | piste 12 en permanence à 0 |
| 1 | 0 | 0 | piste 12 en permanence à 1 |
| 1 | 0 | 1 | aléas de fonctionnement |
| 1 | 1 | 0 | piste 11 en permanence à 1 |
| 1 | 1 | 1 | pistes 11 et 12 en permanence à des valeurs complémentaires ou piste 13 en permanence à 1 |

Ainsi lorsque le triplet M1 M2 M3 prend la valeur 010 et seulement dans ce cas, le fonctionnement est correct.

Le choix de l'opérateur ou exclusif pour le module de jonction J n'est pas unique de même que le vecteur de test peut prendre d'autres valeurs. Ces données doivent être considérées comme des exemples et ne constituent pas une limitation de l'invention.

Le circuit de l'invention se généralise aisément lorsque le nombre d'entrées est inférieur ou égal au double du nombre de sorties. Toutefois, il faut éviter lors de la procédure de test, d'appliquer ou de produire un même signal sur deux pistes adjacentes du circuit imprimé, ce qui pourrait masquer un court-circuit entre celles-ci.

L'invention permet également de raccorder plus de deux entrées sur une seule sortie moyennant un agencement différent du module de jonction selon les principes précédemment énoncés. Le nombre de vecteurs de test nécessaires sera, de fait, augmenté.

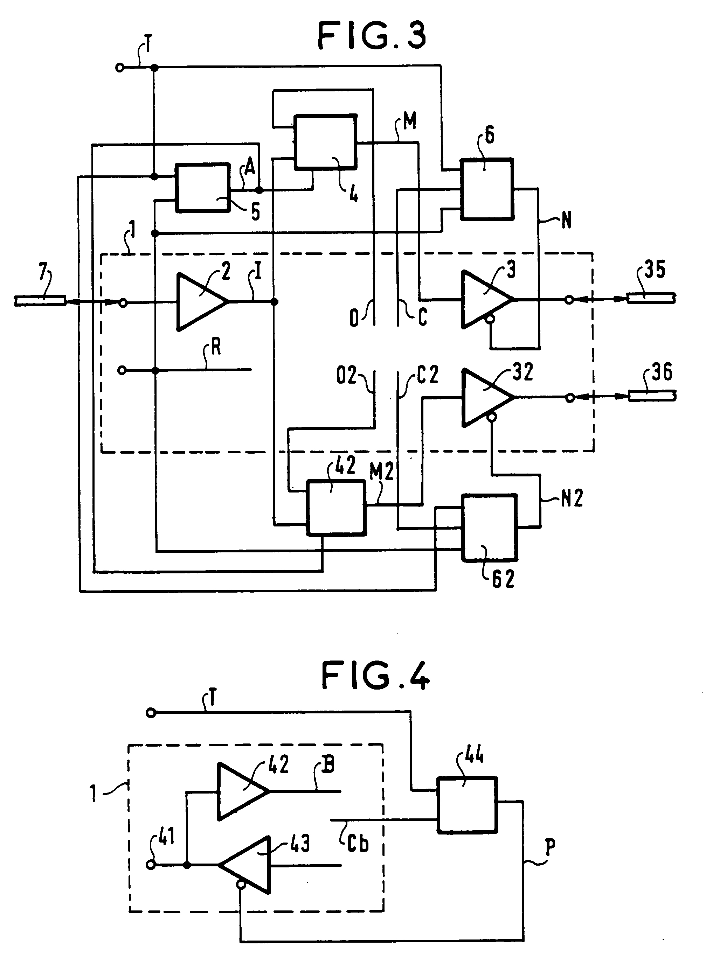

Le cas où circuit intégré comprend un accès d'entrée et deux accès de sortie est représenté à la figure 3.

Le circuit comprend une cellule fonctionnelle 1 qui se distingue de celle décrite au cours du premier cas en ce qu'elle comprend non pas un mais deux accès de sortie. Elle incorpore donc une première 3 et une deuxième 32 cellules d'interface de sortie trois états.

Elle est prévue pour produire un premier 0 et un deuxième 02 signaux de sortie et respectivement un premier C et un deuxième C2 signaux de commandes destinés à commander les cellules d'interface de sortie.

La cellule de test comprend outre les éléments mentionnés dans le premier cas, un module complémentaire qui traite le deuxième accès de sortie de la même manière que le premier. Ce module complémentaire est constitué d'un multiplexeur complémentaire 42 identique au multiplexeur 4 et d'un module de commande complémentaire 62 identique au module de commande 6. Ce multiplexeur complémentaire délivre un signal M2 à destination de la deuxième cellule d'interface de sortie 32 qui prend la valeur du signal d'entrée I ou du deuxième signal de sortie 02 selon que la valeur du signal d'activation est zéro ou un. Le module de commande complémentaire 62 produit un signal N2 à destination de l'entrée de commande de la deuxième cellule d'interface de sortie 32 dont la valeur est donnée par l'équation logique :

$$N2 = \overline{T} . \overline{R} + T . C2$$

La procédure de test en mode dérivation consiste à appliquer un signal témoin prenant successivement les valeurs 1 et un 0 sur la piste d'entrée 7 du circuit imprimé correspondant au signal d'entrée et à vérifier sur les pistes de sortie 35, 36 correspondant respectivement aux sorties des première 3 et deuxième 32 cellules d'interface de sortie que l'information binaire est bien transmise.

Le circuit de l'invention se généralise aisément lorsque le nombre de sorties est inférieur ou égal au double du nombre d'entrées. Toutefois, il faut éviter d'aiguiller une même entrée sur deux sorties correspondant à des pistes adjacentes sur le circuit imprimé, ce qui pourrait masquer un court-circuit entre celles-ci. D'une manière générale, il sera fait en sorte, dans la mesure du possible, de ne pas appliquer ou de ne pas produire un même signal sur deux pistes adjacentes.

Le circuit tel qu'il a été décrit est prévu pour aiguiller une entrée vers deux sorties. Il peut facilement aiguiller une entrée vers un nombre supérieur de sorties par la simple adjonction de modules complémentaires.

Le cas où le circuit intégré comprend un accès bidirectionnel est représenté dans la figure 4.

Un accès bidirectionnel relié au circuit imprimé par une borne 41 comprend une cellule d'interface d'entrée 42 et une cellule d'interface de sortie 43. Cette borne 41 est donc le point commun de l'entrée de la cellule d'interface d'entrée 42 et de la sortie de la cellule d'interface de sortie 43, tandis que le signal bidirectionnel 13 provient de la cellule d'interface d'entrée. Le signal de commande bidirectionnel Cb est le signal qui met la cellule d'interface de sortie 43 à l'état haute impédance. La cellule fonctionnelle 1 est ainsi circonscrite.

Cet accès bidirectionnel doit être positionné en accès d'entrée dans le mode dérivation, doit être mis à l'état haute impédance dans le mode isolement, tandis qu'il doit être commandé par le signal de commande bidirectionnel Cb dans les deux autres modes. Ainsi la cellule d'interface de sortie 43 commandée par un signal de positionnement P doit être mise en haute impédance si le signal de test vaut zéro ou si le signal de commande bidirectionnel Cb vaut 1.

La cellule de test comprend donc un module de positionnement 44 qui produit ce signal de positionnement P répondant à l'équation logique :

$$P = \overline{T} + Cb$$

Lors de la procédure de test, l'accès bidirectionnel sera considéré comme un accès d'entrée, le signal bidirectionnel B équivalent à un signal d'entrée I, I1, I2, faisant l'objet d'un traitement tel que ceux qui ont été précisés ci-dessus.

Des quatre cas précédents, il ressort que la cellule de test selon l'invention s'applique à un circuit intégré ayant des accès d'entrées, des accès de sorties et des accès bidirectionnels en nombres quelconques.

Le circuit intégré comprend une borne de test et une ligne de test conductrice reliée à cette borne et véhiculant le signal de test. Cette borne est prévue pour être raccordée à une piste de test d'un circuit imprimé. Dans une variante de réalisation qui n'est pas représentée dans les figures, le circuit intégré est agencé de manière à ce que la ligne de test reçoive un signal de valeur 1 lorsqu'aucun signal externe n'est appliqué sur la borne de test. Il suffit, par exemple, de relier cette ligne à une source de valeur 1 par l'intermédiaire d'une résistance de forte valeur. Ainsi lorsqu'un signal de valeur 0 est appliqué sur la borne de test, le signal de test vaut zéro, alors que dans tous les autres cas, il vaut un.

L'invention s'applique naturellement au test de circuits imprimés comprenant un ou plusieurs circuits intégrés incorporant chacun une cellule de test telle que décrite ci-dessus. Un tel circuit imprimé, abstraction faite de l'invention, comprend des pistes fonctionnelles telles que des pistes d'alimentation, des pistes d'horloge, des pistes d'interconnexion et, généralement, une piste de remise à zéro pour chaque circuit intégré. Cette piste de remise à zéro peut donc être considéré simultanément comme une piste fonctionnelle et une piste de test. Il comprend de plus, au voisinage de chaque circuit intégré selon l'invention, une autre piste de test raccordée à la borne de test de ce circuit intégré, ces autres pistes de test n'étant pas nécessairement raccordées au connecteur de ce circuit imprimé.

Lorsque tous les composants ont été montés sur le circuit imprimé, celui-ci est introduit dans une machine de test dont l'organe de connexion est du type carte à pointes ou planches à clous. Cet organe de connexion est prévu pour permettre l'accès par un point de test à chaque piste reliée d'un circuit intégré selon l'invention. Selon les dimensions géométriques, et les tolérances de positionnement, un point de test sera une portion d'une piste éventuellement élargie.

Le test du circuit imprimé au voisinage d'un circuit intégré selon l'invention consiste à :

- appliquer un signal de valeur 1 sur la piste de remise à zéro de ce circuit intégré et appliquer un signal de valeur zéro sur la piste raccordée à la borne de test de ce cicuit intégré,
- appliquer un signal de valeur zéro sur les pistes de remise à zéro et sur les bornes de test de tous les autres circuits intégrés,
- effectuer la procédure de test telle qu'elle est décrite dans les premiers, deuxièmes et troisièmes cas du présent document.

L'invention s'applique également lorsque le circuit imprimé comprend une piste unique de remise à zéro à laquelle sont raccordés tous les circuits intégrés selon l'invention. Dans ce cas, il n'est pas possible d'utiliser le signal de remise à zéro R pour commander les cellules de test si le circuit imprimé comprend plusieurs circuits intégrés selon l'invention, car, en phase de test, ceux-ci seraient tous dans le même mode de fonctionnement.

Dans ce cas, une borne supplémentaire, borne de vérification est disposée, sur chaque circuit intégré selon l'invention et autant de pistes de test supplémentaires, pistes de vérification, destinées à être raccordées à ces bornes supplémentaires, sont agencées sur le circuit imprimé. La ligne conductrice d'une cellule de test qui recevait précédemment le signal de remise à zéro est maintenant prévue pour recevoir un signal de vérification par l'intermédiaire d'une borne de vérification étant entendu que ces deux signaux ont un rôle identique vis-à-vis d'une cellule de test.

L'ensemble des procédures de test décrites précédemment s'appliquent si ce n'est qu'au lieu d'agir sur le signal de remise à zéro par l'intermédiaire de la piste de remise à zéro, il faut agir sur le signal de vérification dans les mêmes conditions.

La présente invention permet ainsi de tester simplement et rapidement un circuit imprimé.

Ainsi un circuit intégré comprenant 40 entrées et 40 sorties nécessite de l'ordre de 200 portes pour la cellule de test selon l'invention tandis que selon la spécification JTAG, il faudrait environ 1500 portes supplémentaires.

**Revendications**

1. Système de test d'un circuit imprimé pourvu de circuits intégrés, comprenant un équipement de test muni d'un organe de connexion, un desdits circuits intégrés au moins comprenant une cellule fonctionnelle (1) et une cellule de test, ledit circuit imprimé comprenant des pistes fonctionnelles (7, 8) accédant à ladide cellule fonctionnelle et une piste de test au moins accédant à ladite cellule de test, cette cellule de test comprenant des moyens pour relier une entrée au moins et une sortie au moins de ladite cellule fonctionnelle en réponse à un signal d'activation (A) dérivant de l'état desdites pistes de test, lesdites pistes de test étant propres audit circuit intégré et ledit organe de connexion accédant à chacune desdites pistes de test et desdites pistes fonctionnelles (7, 8), caractérisé en ce que ladite cellule de test comprend, de plus, un module de commande (6) pour produire un signal de neutralisation (N) dérivant de l'état desdites pistes de test, et des moyens pour mettre toutes les sorties de ladite cellule fonctionnelle à l'état haute impédance en réponse audit signal de neutralisation (N).

2. Système de test d'un circuit imprimé pourvu de circuits intégrés selon la revendication 1, caractérisé en ce que ledit circuit intégré comprenant des accès bidirectionnels, ladite cellule de test comprend des moyens pour positionner lesdits accès bidirectionnels en accès d'entrée en réponse à un signal de positionnement (P) dérivant de l'état desdites pistes de test.

3. Système de test d'un circuit imprimé pourvu de circuits intégrés selon l'une quelconque des revendications précédentes, caractérisé en ce que, ladite cellule fonctionnelle (1) étant prévue pour recevoir un signal d'entrée (I) au moins et pour appliquer un signal de sortie (0) au moins à une cellule d'interface de sortie (3), ladite cellule de test étant prévue pour recevoir un signal de test (T) à deux états et un signal de vérification (R) à deux états chacun par une dite piste de test, cette cellule de test comprend un module d'activation (5) produisant ledit signal d'activation (A) pour une combinaison particulière desdits signaux de test (T) et de vérification dite combinaison de dérivation.

4. Système de test d'un circuit imprimé pourvu de circuits intégrés selon la revendication précédente caractérisé en ce que ladite cellule d'interface de sortie (3) étant une cellule trois états, ladite cellule fonctionnelle (1) étant prévue pour produire de plus un signal de commande (C) de ladite cellule d'interface de sortie pour la mettre en état de haute impédance, ledit module de commande (6) de ladite cellule de test reçoit ledit signal de vérification (R), ledit signal de test (T) et ledit signal de commande (C) et produit ledit signal de neutralisation (N) soit pour une combinaison desdits signaux de vérification et de test distincte de ladite combinaison de dérivation dite combinaison d'isolement, soit, si ledit signal de commande est présent, pour les combinaisons desdits signaux de vérification et de test distinctes desdites combinaisons de dérivation et d'isolement.

5. Système de test d'un circuit imprimé pourvu de circuits intégrés selon la revendication 3 ou 4, caractérisé en ce que ladite cellule fonctionnelle (1) comprend un accès bidirectionnel au moins composé d'une cellule d'interface d'entrée particulière (42) et d'une cellule d'interface de sortie particulière (43) et étant prévue pour produire un signal de commande bidirectionnel (Cb) afin de mettre ladite cellule d'interface de sortie particulière (43) à l'état haute impédance, ladite cellule de test comprend un module de positionnement (44) qui produit ledit signal de positionnement (P) soit pour une combinaison desdits signaux de vérification (R) et de test (T) correspondant à ladite combinaison de dérivation ou à ladite combinaison d'isolement soit si ledit signal de commande bidirectionnel (Cb) est présent, le signal bidirectionnel (B) issu de ladite cellule d'interface d'entrée particulière (42) étant alors un dit signal d'entrée.

6. Système de test d'un circuit imprimé pourvu de circuits intégrés selon l'une quelconque des revendications 3 à 5, caractérisé en ce que lesdits moyens de test comprennent un multiplexeur (4, 42) au moins délivrant à une dite cellule d'interface de sortie (3, 32) un signal de multiplex (M) prenant la valeur d'un dit signal d'entrée (I) ou d'un dit signal de sortie (0) selon que ledit signal d'activation (A) est respectivement présent ou absent.

7. Système de test d'un circuit imprimé pourvu de circuits intégrés selon l'une quelconque des revendications précédentes, caractérisé en ce que ladite cellule de test comprend un module de jonction (10) recevant plusieurs desdits signaux d'entrée particuliers (I1, I2) et produisant un signal de jonction (J) qui change de valeur dès qu'un desdits signaux d'entrée particulier (I1, I2) change de valeur, ledit signal de jonction (J) étant dorénavant un dit signal d'entrée.

8. Système de test d'un circuit imprimé pourvu de circuits intégrés, selon la revendication précédente, caractérisé en ce que ledit module de jonction (10) est un opérateur ou exclusif.

9. Système de test d'un circuit imprimé pourvu de circuits intégrés, selon l'une quelconque des revendications 3 à 6, caractérisé en ce que, ladite cellule fonctionnelle étant prévue pour recevoir un signal de remise à zéro (R) qui lui est propre, ledit signal de vérification est ledit signal de remise à zéro.

10. Système de test d'un circuit imprimé pourvu de circuits intégrés, selon l'une des revendications 7 ou 8, caractérisé en ce que ladite cellule fonctionnelle étant prévue pour recevoir un signal de remise à zéro (R) qui lui est propre, ledit signal de vérification est ledit signal de remise à zéro.

11. Application du système de test d'un circuit imprimé pourvu de circuits intégrés selon l'une quelconque des revendications 3 à 6 ou 9. caractérisé en ce que ledit équipement de test transmet un dit signal de test (T) et un dit signal de vérification (R) correspondant à la combinaison de dérivation un dit circuit intégré dit circuit cible, transmet à tous les autres circuits intégrés comprenant une dite cellule de test des signaux de test et de vérification correspondant à la combinaison d'isolement, vérifie la transmission d'un signal témoin pour ses deux états d'une piste fonctionnelle d'entrée (7) à une piste fonctionnelle de sortie (8) au moins dudit circuit cible.

12. Application du système de test d'un circuit imprimé pourvu de circuits intégrés selon l'une quelconque des revendications 7, 8 ou 10, caractérisé en ce que ledit équipement de test transmet un dit signal de test (T) et undit signal de vérification (R) correspondant à ladite combinaison de dérivation à un dit circuit intégré dit circuit cible, transmet à tous les autres circuits intégrés comprenant une dite cellule de test des signaux de test et de vérification correspondant à la combinaison d'isolement, vérifie la transmission dudit signal de jonction à la piste de sortie (13) correspondante dudit circuit cible tandis que des signaux témoins à deux états sont appliqués selon plusieurs combinaisons sur chaque piste fonctionnelle (11, 12) correspondant à un dit signal particulier d'entrée (I1, I2), une combinaison desdits signaux témoins se déduisant d'une autre combinaison par modification d'un seul dit signal témoin, chacun desdits signaux témoins étant alternativement dans ses deux états.

13. Circuit intégré comprenant une cellule fonctionnelle et une cellule de test, conforme à l'une quelquonque des

EP 0 453 758 B1

revendications 1 à 10.

**Patentansprüche**

1. System zur Überprüfung einer Druckschaltungskarte mit integrierten Schaltungen, das eine mit einem Anschlußorgan versehene Testeinrichtung enthält, wobei mindestens eine der integrierten Schaltungen eine funktionale Zelle (1) und eine Testzelle enthält und wobei die Druckschaltungskarte funktionale Leitbahnen (7, 8), die zu der funktionalen Zelle führen, und mindestens eine Testleitbahn besitzt, die zur Testzelle führt, wobei diese Testzelle Mittel besitzt, um mindestens einen Eingang und mindestens einen Ausgang der funktionalen Zelle abhängig von einem Aktivierungssignal (A) zu verbinden, das vom Zustand der Testleitbahnen abhängt, wobei diese Testleitbahnen der integrierten Schaltung zugeordnet sind und das Anschlußorgan zu jeder der Testleitbahnen und der funktionalen Leitbahnen (7, 8) Zugang hat, dadurch gekennzeichnet, daß die Testzelle außerdem einen Steuermodul (6), um ein vom Zustand der Testleitbahnen abhängiges Neutralisierungssignal (N) zu erzeugen, sowie Mittel enthält, um alle Ausgänge der funktionalen Zelle in den Zustand hoher Impedanz aufgrund des Neutralisierungssignals (N) zu bringen.

2. System zur Überprüfung einer Druckschaltungskarte mit integrierten Schaltungen nach Anspruch 1, dadurch gekennzeichnet, daß die Testzelle für eine integrierte Schaltung, die bidirektionale Zugänge besitzt, Mittel aufweist, um diese bidirektionalen Zugänge zu Eingangszugängen abhängig von einem Schaltsignal (P) zu machen, das vom Zustand der Testleitbahnen abhängt.

3. System zur Überprüfung einer Druckschaltungskarte mit integrierten Schaltungen nach einem beliebigen der vorhergehenden Ansprüche, dadurch gekennzeichnet, daß, wenn die funktionale Zelle (1) für den Empfang mindestens eines Eingangssignals (I) und zur Ausgabe mindestens eines Ausgangssignals (0) an eine Ausgangs-Schnittstellenzelle (3) vorgesehen ist, während die Testzelle ein Testsignal (T) mit zwei Zuständen und ein Verifiziersignal (R) mit zwei Zuständen je über eine Testbahn empfängt, die Testzelle einen Aktivierungsmodul (5) enthält, der das Aktivierungssignal (A) für eine bestimmte Kombination der Testsignale und Verifiziersignale erzeugt, die Ableitungskombination genannt wird.

4. System zur Überprüfung einer Druckschaltungskarte mit integrierten Schaltungen nach dem vorhergehenden Anspruch, dadurch gekennzeichnet, daß die Ausgangs-Schnittstellenzelle (3) eine Zelle mit drei Zuständen ist, daß die funktionale Zelle (1) außerdem ein Signal (C) zur Steuerung der Ausgangs-Schnittstellenzelle erzeugen kann, um diese in den Zustand hoher Impedanz zu bringen, daß der Steuermodul (6) der Testzelle das Verifiziersignal (R), das Testsignal (T) und das Steuersignal (C) empfängt und das Neutralisierungssignal (N) entweder für eine Kombination der Verifizier- und Testsignale, die sich von der Ableitungskombination unterscheidet und Isolierkombination genannt wird, oder, wenn das Steuersignal vorliegt, für die Kombinationen der Verifizierund Testsignale erzeugt, die sich von der Ableitungs- und der Isolierkombination unterscheiden.

5. System zur Überprüfung einer Druckschaltungskarte mit integrierten Schaltungen nach Anspruch 3 oder 4, dadurch gekennzeichnet, daß die funktionale Zelle (1) mindestens einen bidirektionalen Zugang, bestehend aus einer besonderen Eingangs-Schnittstellenzelle (42) und einer besonderen Ausgangs-Schnittstellenzelle (43) besitzt, der ein bidirektionales Steuersignal (Cb) erzeugen kann, um diese besondere Ausgangs-Schnittstellenzelle (43) in den Zustand hoher Impedanz zu bringen, daß die Testzelle einen Schaltmodul (44) aufweist, der das Schaltsignal (P) entweder für eine Kombination der Verifizier- und Testsignale (R, T) entsprechend der Ableitungskombination oder der Isolationskombination erzeugt, oder wenn das bidirektionale Steuersignal (Cb) vorliegt, wobei dann das bidirektionale Signal (B), das von der besonderen Eingangs-Schnittstelle (42) stammt, ein Eingangssignal ist.

6. System zur Überprüfung einer Druckschaltungskarte mit integrierten Schaltungen nach einem beliebigen der Ansprüche 3 bis 5, dadurch gekennzeichnet, daß die Testmittel mindestens einen Multiplexer (4, 42) aufweisen, der an eine Ausgangs-Schnittstellenzelle (3, 32) ein Multiplexsignal (M) liefert, das den Wert eines Eingangssignals (I) oder Ausgangssignals (O) annimmt, je nachdem, ob das Aktivierungssignal (A) vorliegt oder nicht.

7. System zur Überprüfung einer Druckschaltungskarte mit integrierten Schaltungen nach einem beliebigen der vorhergehenden Ansprüche, dadurch gekennzeichnet, daß die Testzelle einen Verknüpfungsmodul (10) enthält, der mehrere besondere Eingangssignale (I1, I2) empfängt und ein Verknüpfungssignal (J) erzeugt, der seinen Wert ändert, sobald eines der besonderen Eingangssignale (I1, i2) seinen Wert ändert, wobei das Verknüpfungssignal (J) dann ein Eingangssignal ist.

8. System zur Überprüfung einer Druckschaltungskarte mit integrierten Schaltungen nach dem vorhergehenden Anspruch, dadurch gekennzeichnet, daß der Verknüpfungsmodul (10) ein Exklusiv-ODER-Operator ist.

9. System zur Überprüfung einer Druckschaltungskarte mit integrierten Schaltungen nach einem beliebigen der Ansprüche 3 bis 6, dadurch gekennzeichnet, daß das Verifiziersignal, wenn die funktionale Zelle ein eigenes Nullsetzungssignal (R) empfangen kann, dieses Nullsetzungssignal ist.

10. System zur Überprüfung einer Druckschaltungskarte mit integrierten Schaltungen nach einem der Ansprüche 7 oder 8, dadurch gekennzeichnet, daß das Verifiziersignal, wenn die funktionale Zelle ein eigenes Nullsetzungssignal (R) empfangen kann, dieses Nullsetzungssignal ist.

11. Anwendung des Systems zur Überprüfung einer Druckschaltungskarte mit integrierten Schaltungen nach einem beliebigen der Ansprüche 3 bis 6 oder 9, dadurch gekennzeichnet, daß die Testeinrichtung ein Testsignal (T) und ein Verifizierungssignal (R) entsprechend der Ableitungskombination an eine integrierte Schaltung überträgt, die Zielschaltung genannt wird, sowie Test- und Verifiziersignale entsprechend der Isolierungskombination an alle anderen integrierten Schaltungen, die eine Testzelle besitzen, und daß die Übertragung eines Prüfsignals für dessen beide Zustände zwischen einer funktionalen Eingangsleitbahn (7) und mindestens einer funktionalen Ausgangsleitbahn (8) der Zielschaltung verifiziert wird.

12. Anwendung des Systems zur Überprüfung einer Druckschaltungskarte mit integrierten Schaltungen nach einem beliebigen der Ansprüche 7, 8 oder 10, dadurch gekennzeichnet, daß die Testeinrichtung ein Testsignal (T) und ein Verifizierungssignal (R) entsprechend der Ableitungskombination an eine integrierte Testschaltung, Zielschaltung genannt, und Test-und Verifizierungssignale entsprechend der Isolierungskombination an alle anderen integrierten Schaltungen, die eine Testzelle besitzen, überträgt und die Übertragung des Verknüpfungssignals auf die entsprechende Ausgangsleitbahn (13) der Zielschaltung verifiziert wird, während Prüfsignale mit zwei Zuständen gemäß mehreren Kombinationen an jede funktionale Leitbahn (11, 12) entsprechend einem besonderen Eingangssignal (I1, I2) angelegt werden, wobei eine Kombination der Prüfsignale sich von einer anderen Kombination durch Veränderung nur eines der Prüfsignale ableitet und jedes der Prüfsignale abwechselnd in einem seiner beiden Zustände ist.

13. Integrierte Schaltung nach einem beliebigen der Ansprüche 1 bis 10.

## Claims

1. System for testing a printed circuit carrying integrated circuits, the system comprising a test equipment having a connection unit, at least one of said integrated circuits comprising a functional cell (1) and a test cell, said printed circuit comprising functional tracks (7, 8) connected to said functional cell and a test track connected at least to said test cell, said test cell comprising means for connecting at least one input and at least one output of said functional cell in response to an activation signal (A) conditioned by the state of said test tracks, said test tracks being specific to said integrated circuit and said connection unit accessing each of said test tracks and each of said functional tracks (7, 8), characterised in that said test cell further comprises a control module (6) to produce a neutralisation signal (N) conditioned by the state of said test tracks and means for placing all outputs of said functional cell in a high impedance state in response to said neutralisation signal (N).

2. System according to claim 1 for testing a printed circuit carrying integrated circuits, characterised in that said integrated circuit comprising bidirectional ports, said test cell comprises means for setting said bidirectional ports to input mode in response to a positioning signal (P) conditioned by the state of said test tracks.

3. System according to claim 1 or claim 2 for testing a printed circuit carrying integrated circuits, characterised in that, said functional cell (1) being adapted to receive at least one input signal (I) and to apply at least one output signal (O) to an output interface cell (3), and said test cell being adapted to receive a two-state test signal (T) and a two-state verification signal (R) from respective test tracks, said test cell comprises an activation module (5) producing said activation signal (A) for a particular combination of said test (T) and verification signals constituting a bypass combination.

**4.** System according to claim 3 for testing a printed circuit carrying integrated circuits, characterised in that said output interface cell (3) being a tristate cell, said functional cell (1) being adapted additionally to produce a control signal (C) of said output interface cell to place it in the high impedance state, said control module (6) of said test circuit receives said verification signal (R), said test signal (T) and said control signal (C) and produces said neutralisation signal (N) either for a combination of said verification and test signals different from said bypass combination constituting an isolation combination or, if said control signal is present, for the combinations of said verification and test signals different from said bypass and isolation combinations.

**5.** System according to claim 3 or claim 4 for testing a printed circuit carrying integrated circuits, characterised in that said functional cell (1) comprises at least one bidirectional port consisting of a particular input interface cell (42) and a particular output interface cell (43) and being adapted to produce a bidirectional control signal (Cb) in order to place said particular output interface cell (43) in the high impedance state, said test cell comprises a positioning module (44) which produces said positioning signal (P) either for a combination of said verification (R) and test (T) signals corresponding to said bypass combination or to said isolation combination or, if said bidirectional control signal (Cb) is present, the bidirectional signal (B) from said particular input interface cell (42) being then one of said input signals.

**6.** System according to any one of claims 3 to 5 for testing a printed circuit carrying integrated circuits, characterised in that said test means comprise at least one multiplexer (4, 42) delivering to one of said output interface cells (3, 32) a multiplex signal (M) taking the value of one of said input signals (I) or one of said output signals (O) according to whether said activation signal (A) is respectively present or absent.

**7.** System according to any one of the preceding claims for testing a printed circuit carrying integrated circuits, characterised in that said test cell comprises a junction module (10) receiving a plurality of said particular input signals (I1, I2) and producing a junction signal (J) which changes value as soon as one of said particular input signals (I1, I2) changes value, said junction signal (J) being thereafter one of said input signals.

**8.** System according to claim 7 for testing a printed circuit carrying integrated circuits, characterised in that said junction module (10) is an exclusive-OR operator.

**9.** System according to any one of claims 3 to 6 for testing a printed circuit carrying integrated circuits, characterised in that, said functional cell being adapted to receive a reset signal (R) specific to it, said verification signal is said reset signal.

**10.** System according to claim 7 or claim 8 for testing a printed circuit carrying integrated circuits, characterised in that, said functional cell being adapted to receive a reset signal (R) specific to it, said verification signal is said reset signal.

**11.** Application of the system according to any one of claims 3 to 6 or 9 for testing a printed circuit carrying integrated circuits, characterised in that said test equipment transmits one of said test signals (T) and one of said verification signals (R) corresponding to the bypass combination to one of said integrated circuits constituting a target circuit, transmits to all the other integrated circuits comprising one of said test cells test and verification signals corresponding to the isolation combination, verifies the transmission of a stimulus signal for its two states from an input functional track (7) to at least one output functional track (8) of said target circuit.

**12.** Application of the system according to any one of claims 7, 8 and 10 for testing a printed circuit carrying integrated circuits, characterised in that said test equipment transmits of said test signals (T) and one of said verification signals (R) corresponding to said bypass combination to one of said integrated circuits constituting a target circuit, transmits to all the other integrated circuits comprising one of said test cells test and verification signals corresponding to the isolation combination, verifies transmission of said junction signal to the corresponding output track (13) of said target circuit, and two-state stimulus signals are applied in a plurality of combinations to each functional track (11, 12) corresponding to one of said particular input signals (I1, I2), a combination of said stimulus signals being deduced from another combination by modification of one only of said stimulus signals, each of said stimulus signals being in each of its two states alternately.

**13.** Integrated circuit according to any one of claims 1 to 10.

EP 0 453 758 B1

FIG.1

FIG.2

12

# FIG.3

# FIG.4